# EUROPEAN PATENT APPLICATION

(11) **EP 4 645 033 A1**
(43) Date of publication of application: **05.11.2025**
(21) Application number: 25171737.7
(22) Date of filing: 22.04.2025
(51) Int. Cl.: G06F 1/18

(54) **POWER CONVERSION SYSTEM**

(30) Priority: 29.04.2024 CN 202420923371 U
(71) Applicant: Anker Innovations Technology Co., Ltd., Changsha, Hunan 410000 (CN)
(72) Inventor: ZENG, Anfu, Shenzhen (CN); LUO, Jianguo, Shenzhen (CN); OUYANG, Yi, Shenzhen (CN); XUAN, Denghui, Shenzhen (CN)
(74) Representative: Steffens, Adrian

(57) **Abstract**

Disclosed is a power conversion system, comprising a case (1), a screen display module (3), and a light transmission module (4). A control board is provided in the case (1), the case (1) has a surface cover (2), the screen display module (3) is located outside the case (1) and detachably mounted on the surface cover (2), the screen display module (3) is electrically connected to the control board, and the light transmission module (4) covers the screen display module (3) and is detachably mounted on the surface cover (2). When disassembling and replacing, a user only needs to remove the light transmission module (4) from the surface cover (2). The screen display module (3) comprises a human body detection radar (31) and a display screen (32) distributed on the surface cover (2), so the human body detection radar (31) and/or the display screen (32) can be directly disassembled and replaced, without disassembling the surface cover (2). Therefore, circuit components inside the case (1) will not be affected, and the subsequent waterproof effect will also not be affected.

## Description

### Technical field

The present application relates to the technical field of electronic devices, in particular to a power conversion system with a case.

### Background

In application scenarios of existing electronic devices, parts inside a surface cover, such as a display screen and a human body sensing radar, are inevitably replaced. Taking a common PCS (Power Conversion System) case as an example, when such a situation occurs, a specific technical solution in the prior art includes disassembling the large surface cover located on one side from the case and then disassembling the part that needs to be replaced from the surface cover for replacement.
(1) Generally, a user's PCS is mounted on a wall, that is, the PCS is connected and assembled with a battery pack and then fixed to the wall. When the surface cover of the PCS case is disassembled to replace the screen display structure, it is inconvenient to remove the PCS from the wall;
(2) During the process of disassembling the case and the surface cover, directly exposed circuit components inside the PCS may be damaged and the service life of the entire PCS may be affected;
(3) Dismantling and then re-locking the surface cover may affect the overall airtightness of the case and affect the subsequent waterproof effect.

### Summary

A power conversion system according to claim 1 is provided, which can solve the problems that it is inconvenient to disassemble a conventional surface cover, electronic components are prone to damage, and the subsequent waterproof effect is affected. Embodiments are the subject matter of dependent claims.

According to an aspect of the present application, a power conversion system is provided, including a case, a screen display module, and a light transmission module, where a control board is provided in the case, the case has a surface cover, the screen display module is located outside the case and detachably mounted on the surface cover, the screen display module is electrically connected to the control board, and the light transmission module covers the screen display module and is detachably mounted on the surface cover, where the screen display module includes a human body detection radar and a display screen, the human body detection radar and the display screen are spaced apart on the surface cover, the human body detection radar is connected to the control board in the case through a first wire harness, and the display screen is connected to the human body detection radar through a second wire harness.

Based on the power conversion system in the embodiment of the present application, when disassembling and replacing, a user only needs to open the light transmission module on the surface cover, and then replace the human body detection radar and/or the display screen in the screen display module according to actual needs, without disassembling the surface cover. Therefore, circuit components inside the PCS case will not be affected, and the subsequent waterproof effect will also not be affected.

In some embodiments, the human body detection radar includes a radar body and/or a sealing cover. Preferably, the radar body is connected to the surface cover and/or connected to the control board in the case through the first wire harness and/or the sealing cover is detachably mounted on the surface cover and/or covers the radar body.

Based on the above embodiments, the radar body is sealed and protected, to prevent external air and water from entering the case through the place where the wire harness of the radar body passes through the surface cover.

In some embodiments, a first wire hole is formed on the sealing cover. Preferably, a waterproof plug is embedded in the first wire hole and/or a channel that allows the second wire harness to pass through is formed in the waterproof plug.

Based on the above embodiments, the waterproof plug is provided at the position where the display screen passes through the sealing cover, which can prevent water and air from entering the sealing cover and further ensure the dustproof and waterproof level.

In some embodiments, the screen display module further includes a light strip. The light strip is connected to the human body detection radar through a third wire harness. Alternatively or additionally, the second wire harness includes one first terminal and two second terminals. Preferably, the first terminal is connected to the human body detection radar and the two second terminals are connected to the light strip and the display screen respectively.

Based on the above embodiments, the light strip not only adds a decorative effect for the screen display module to improve overall aesthetics but can also adjust its brightness and color as needed to create different atmospheres. By designing the wire harness connection, the light strip and display screen components can be easily added or replaced.

In some embodiments, a portion of the side of the surface cover facing the screen display module is recessed inwards to form a mounting groove, the screen display module is arranged at a bottom of the mounting groove. Preferably, when the light transmission module is mounted on the surface cover, the side of the light transmission module facing away from the surface cover is flush with an opening of the mounting groove.

Based on the above embodiment, the side of the entire surface cover facing the screen display module is a flat surface, and the screen display module does not protrude from the surface cover, thereby achieving a function of preventing accidental contact and ensuring overall aesthetics.

In some embodiments, a display area is provided on the side of the surface cover facing the screen display module. Preferably, the display area transitions to the bottom of the mounting groove through a slope surface and/or the light strip is arranged on the side of the groove bottom near or at the slope surface to illuminate the display area and/or the light strip has multiple working modes, and when the light strip is in different working modes, the light transmission module shows different light output effects.

Based on the above embodiments, the light strip can illuminate the display area to highlight articles to be displayed in the display area. On the other hand, the light transmission module shows different light output effects, which not only meets the requirements of diverse and aesthetic light, but also can inform the user of the state of the power conversion system according to different light.

In some embodiments, the light strip includes a segment of continuous light components and/or a plurality of light components spaced apart. The light strip, in particular at least one of or each of the continuous light components and/or the light components spaced apart includes a shell and a light strip body. Preferably, the shell is formed with a mounting chamber, and/or the shell is detachably connected to the surface cover and/or the light strip body is fitted into the mounting chamber.

Based on the above embodiments, the user is provided with more mounting options and more lighting options, and the light strip body is mounted in the shell, which can provide certain protecting and limiting effects on the light strip body.

In some embodiments, the light transmission module includes a back plate. Preferably, the back plate is detachably mounted on the surface cover and/or the display screen is detachably mounted on the back plate.

Based on the above embodiments, the light transmission module, the surface cover, and the display screen can be quickly disassembled.

In some embodiments, the back plate is provided with a first notch and the display screen is correspondingly arranged in the first notch; and/or the back plate is further provided with a second notch, and the human body detection radar is correspondingly arranged in the second notch.

Based on the above embodiments, the first notch facilitates better display of the display screen through the light transmission module, and the second notch can reduce the shielding effect of the back plate on the human body detection radar.

In some embodiments, the light transmission module further includes a transparent protective layer. Preferably; the transparent protective layer and/or the back plate and/or the screen display module are distributed sequentially; where in particular an adhesive layer is provided between the transparent protective layer and the back plate, preferably to connect the transparent protective layer and the back plate.

Based on the above embodiments, the transparent protective layer does not affect the display of the screen display module, can provide additional protection for the screen display module, and can effectively prevent the screen display module from physical damage such as scratch and collision. Meanwhile, the transparent protective layer can resist the erosion of chemicals and stains and keep the screen display module clean and intact.

The power conversion system based on the embodiments of the present application includes a case, a screen display module, and a light transmission module, where the case has a surface cover, the screen display module is located outside the case and detachably mounted on the surface cover, and the light transmission module covers the screen display module to achieve a light transmission function; meanwhile, the light transmission module is detachably mounted on the surface cover, so when disassembling and replacing, the user only needs to remove the light transmission module from the surface cover; the screen display module includes a human body detection radar and a display screen distributed on the surface cover, so the human body detection radar and/or the display screen can be directly disassembled and replaced according to actual needs, without disassembling the surface cover; therefore, circuit components inside the case will not be affected, and the subsequent waterproof effect will also not be affected.

### Brief description of drawings

To describe the technical solutions in the embodiments of the present application or in the prior art more clearly, the following briefly introduces the accompanying drawings required for describing the embodiments or the prior art. Apparently, the accompanying drawings in the following description show only some embodiments of the present application, and those skilled in the art can derive other drawings from the accompanying drawings without any creative efforts.
- FIG. 1: is an exploded structural diagram of a surface cover of a power conversion system provided in an embodiment of the present application;
- FIG. 2: is an enlarged schematic diagram of a structure at part A in FIG. 1;
- FIG. 3: is an exploded diagram of a screen display module and a back plate provided in an embodiment of the present application;
- FIG. 4: is a schematic structural diagram of the surface cover and a light transmission module provided in an embodiment of the present application in a mounting state;
- FIG. 5: is a schematic structural diagram of the power conversion system provided in an embodiment of the present application in a mounting state; and
- FIG. 6: is an exploded structural diagram of the power conversion system provided in an embodiment of the present application.

Reference numerals: 1. Case; 11. Base; 12. Decorative cover plate; 2. Surface cover; 2a. Mounting groove; 2b. Display area; 2c. Slope surface; 3. Screen display module; 31. Human body detection radar; 311. Radar body; 312. Sealing cover; 32. Display screen; 321. Mounting seat; 322. Display screen body; 33. Light strip; 331. Shell; 332. Light strip body; 4. Light transmission module; 41. Back plate; 41a. First notch; 41b. Second notch; 42. Transparent protective layer.

### Detailed description

In order to make the objectives, technical solutions, and advantages of the present application clearer, the following further describes the present application in detail in conjunction with the accompanying drawings and embodiments. It should be understood that the specific embodiments described herein are merely used for explaining the present application, but are not used for limiting the present application.

The prior art has the technical problems that it is inconvenient to disassemble a conventional surface cover from an entire case, electronic components inside the case are prone to damage and the subsequent waterproof effect is affected.

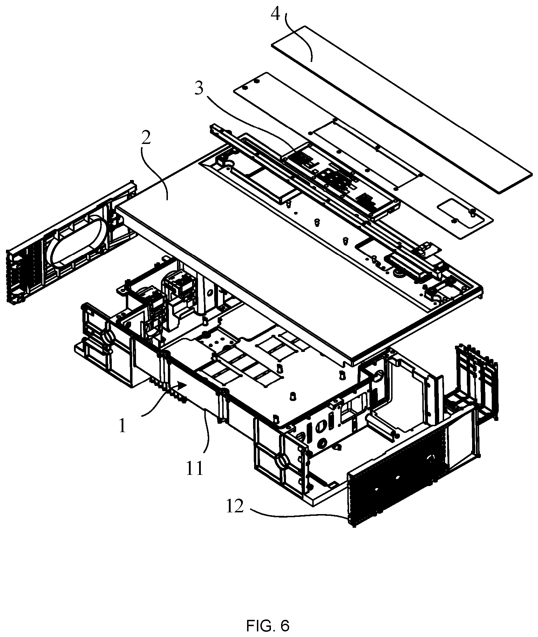

In order to solve the above technical problems, the present application provides a power conversion system, which is applied in an energy storage system and connected between a battery system and a power grid to achieve bidirectional conversion of electrical energy. Specifically, the power conversion system can convert direct current of a battery into alternating current, which is then transmitted to the power grid or used by an alternating current load; or the power conversion system can rectify alternating current of the power grid into direct current, which is then charged to the battery. As shown in FIG. 6, the power conversion system includes a case 1, a screen display module 3, and a light transmission module 4.

The case 1 includes a base 11 and decorative cover plates 12 located on two sides. The decorative cover plates 12 on the two sides are detachably mounted on the base 11 by bolt connection, fastener connection, etc. The base 11 and the decorative cover plates 12 enclose and form an accommodating chamber, a control board (not shown) is provided in the accommodating chamber, and the control board is mounted on the base 11. The case 1 has a surface cover 2. The surface cover 2 can be detachably mounted above the base 11 by bolt connection, fastener connection, etc., and seals the accommodating chamber to ensure the overall sealing effect of the accommodating chamber.

The screen display module 3 is located outside the case 1, namely, outside the accommodating chamber, and can be detachably mounted on the surface cover 2 by screw connection, fastener connection, or insertion. The screen display module 3 includes a human body detection radar 31 and a display screen 32 spaced apart on the surface cover 2, the human body detection radar 31 is connected to the control board in the case 1 through a first wire harness, and the display screen 32 is connected to the human body detection radar 31 through a second wire harness. That is, the control board leads out, passes through the surface cover 2 and then is connected to the human body detection radar 31, and the display screen 32 leads out and is connected to the human body detection radar 31. As such, the display screen 32 does not need to be connected to the control board in the case 1, thereby reducing exchange contact inside and outside the case 1 and providing convenience to replace the light strip 33 and/or the display screen 32.

The display screen 32 and the human body detection radar 31 are staggered and do not interfere with each other. Understandably, in order to better display the content on the display screen 32, the display screen 32 is generally arranged below the middle of the light transmission module 4.

The light transmission module 4 covers the screen display module 3. The light transmission module 4 can be made of a transparent material such as glass or a plastic board, such that light can be transmitted to the screen display module 3 by the light transmission module 4, or transmitted to the light transmission module 4 by the screen display module 3. The light transmission module 4 can be detachably mounted on the surface cover 2 by screw connection or fastener connection.

In the embodiment of the present application, the screen display module 3 is located outside the case 1 and detachably mounted on the surface cover 2, while the light transmission module 4 covers the screen display module 3 to achieve a light transmission function. Meanwhile, the light transmission module 4 is detachably mounted on the surface cover 2. When disassembling and replacing, the user only needs to remove the light transmission module 4 from the surface cover 2, and then replace the human body detection radar 31 and/or the display screen 32 in the screen display module 3 without separating the surface cover 2 from the case 1. Therefore, circuit components inside the case 1 will not be affected, and the subsequent waterproof effect will also not be affected.

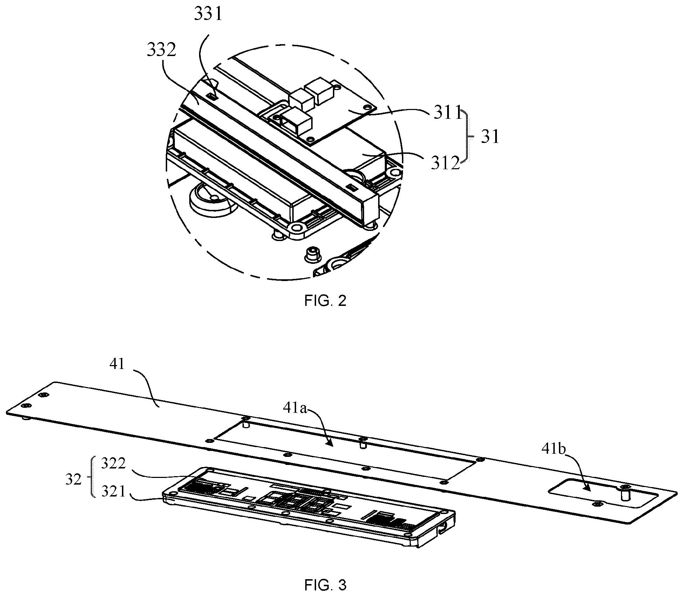

In order to further reduce the exchange contact inside and outside the case 1, as shown in FIG. 2, the human body detection radar 31 includes a radar body 311 and a sealing cover 312, the radar body 311 is connected to the surface cover 2 and connected to the control board in the case 1 through the first wire harness, and the sealing cover 312 is detachably mounted on the surface cover 2 and completely covers the radar body 311 to ensure a good sealing effect.

Because the first wire harness, which connects the human body detection radar 31 and the control board, passes through the surface cover 2, a second wire hole is reserved on the surface cover 2 to allow the first wire harness to pass through. As such, there is a certain gap between the first wire harness and the wall of the second wire hole, which affects the sealing property of the case 1. Therefore, the sealing cover 312 is provided to ensure certain sealing property.

On the other hand, the radar body 311 is a vulnerable part, which is susceptible to external environmental interference, such as water, dust, and light, so the sealing cover 312 can provide some protection for the radar body.

In order to achieve convenient disassembly, the sealing cover 312 can be detachably mounted on the surface cover 2 by fastener connection, screw connection, etc.

On the basis of the previous embodiment, a first wire hole is formed on the sealing cover 312, a waterproof plug (not shown) is embedded in the first wire hole, and a channel that allows the second wire harness to pass through is formed in the waterproof plug.

Because the display screen 32 is connected to the human body detection radar 31 through the second wire harness, the second wire harness passes through the sealing cover 312 via the first wire hole. As such, there is still a certain gap between the inner wall of the first wire hole and the second wire harness, and water and dust may still enter the sealing cover 312 to damage the radar body 311. Therefore, the waterproof plug is embedded in the first wire hole, and the channel that allows the second wire harness to pass through is formed in the waterproof plug.

The waterproof plug may be an elastic rubber plug, such as a rubber waterproof plug or a silicone waterproof plug. After the waterproof plug is squeezed and deformed, the channel therein can be tightly attached to the second wire harness. The waterproof plug can also be attached to the inner wall of the first wire hole, which can maximize the sealing effect of the sealing cover 312.

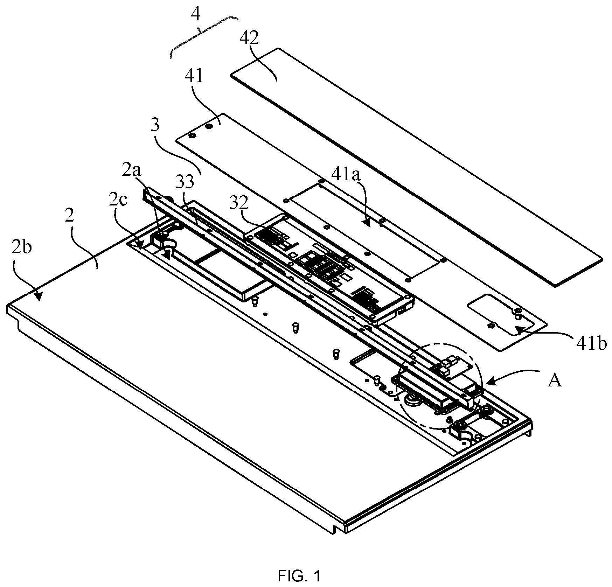

With reference to FIG. 1, the screen display module 3 further includes a light strip 33, the light strip 33 is located below the light transmission module 4 and detachably connected to the surface cover 2 by fasteners such as screws, the light strip 33 extends along a length direction of the surface cover 2, and the display screen 32 and the human body detection radar 31 are staggered and do not interfere with each other. The light strip 33 not only adds a decorative effect for the screen display module 3 to improve overall aesthetics, but also can adjust its brightness and color as needed to create different atmospheres. When the human body detection radar 31 senses a human activity, the light strip can automatically light up or change its color, thereby providing visual feedback to the user and enhancing the interaction experience between the user and the device.

Parameters of the light strip 33, such as brightness and color, can be personalized by the control panel to meet the requirements of different users or scenarios. Meanwhile, combined with the function of the human body detection radar 31, when no person approaches, the light strip 33 can automatically reduce its brightness or turn off to achieve an energy-saving effect.

The light strip 33 is connected to the human body detection radar 31 through a third wire harness. The third wire harness enables the human body detection radar 31 to supply power to the light strip 33. Secondly, the third wire harness can also play a role in signal transmission. The third wire harness is designed specifically for power supply and signal transmission of the light strip 33, such that the connection between the light strip 33 and the human body detection radar 31 is independent of the display screen 32, which reduces the possibility of mutual interference. When the light strip 33 is replaced or repaired, only the third wire harness needs to be handled without affecting the connection of other components.

In some embodiments, the second wire harness includes one first terminal and two second terminals, the first terminal is connected to the human body detection radar 31, and the two second terminals are connected to the light strip 33 and the display screen 32 respectively. By optimizing the design of wire harnesses, the quantity of wire harnesses is reduced, thereby reducing manufacturing costs.

Understandably, regardless of the above connections, both the second wire harness and the third wire harness can pass through the waterproof plug, which can effectively improve the sealing effect.

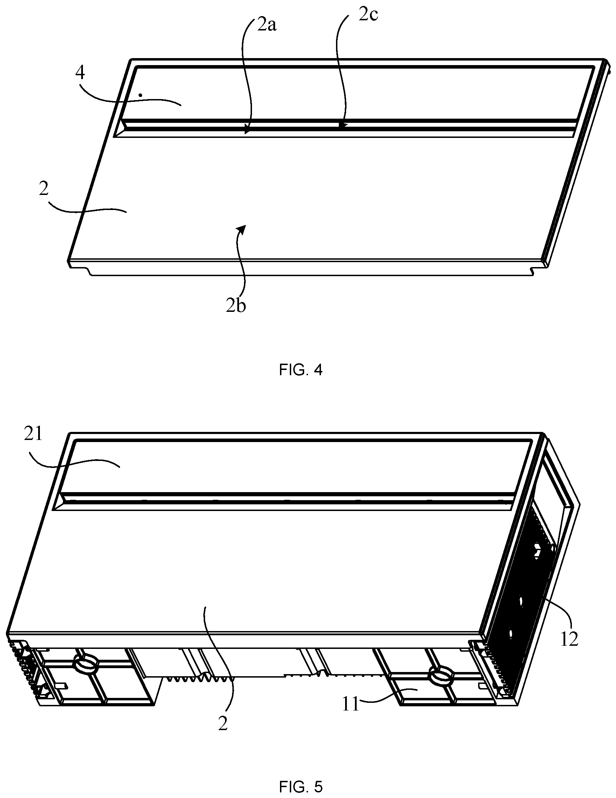

With reference to FIG. 1 and FIG. 4, a portion of the side of the surface cover 2 facing the screen display module 3 is recessed inwards to form a mounting groove 2a, and the screen display module 3 is arranged at a bottom of the mounting groove 2a. The shape of the mounting groove 2a is not limited and may be square, spherical, or conical. The mounting groove 2a provides a mounting space for the screen display module 3 and the light transmission module 4. When the light transmission module 4 is mounted on the surface cover 2, the side of the light transmission module 4 facing away from the surface cover 2 is flush with an opening of the mounting groove 2a.

As such, the side of the light transmission module 4 that is flush with the opening of the mounting groove 2a is also flush with the remaining non-recessed area of the surface cover 2, making the entire surface cover 2 neat. The light transmission module 4 does not protrude relative to the surface cover 2, which also reduces the risk of injury to some extent.

With continued reference to FIG. 4, specifically, a display area 2b is provided on the side of the surface cover 2 facing the screen display module 3. The display area 2b can be printed or engraved with promotional slogans or some signs on its surface. The display area 2b transitions to the bottom of the mounting groove 2a through a slope surface 2c, and the light strip 33 is arranged on the side of the groove bottom near the slope surface 2c to illuminate the display area 2b.

As shown in FIG. 1, the slope surface 2c may be a side wall of the mounting groove 2a and connects its opening and bottom. In the presence of the slope surface 2c, the area of the opening is greater than that of the groove bottom. Light emitted by the light strip 33 illuminates the display area 2b through the slope surface 2c, making the promotional slogans or some signs there more prominent, improving the display effect and enhancing the overall aesthetics of the product.

In other embodiments, the light strip 33 has multiple working modes. When the light strip 33 is in different working modes, the light transmission module 4 shows different light output effects.

The working modes can be set according to user selection. For example, when the power of the entire power conversion system is sufficient, the light strip 33 shows green light; when the power is insufficient, the light strip 33 shows red light; when a high temperature occurs inside the case 1, the light strip 33 can emit red and green alternating light. The specific connection relationship is generally electrical connection, which is the prior art and will not be explained further here.

Specifically, the light strip 33 may be provided in at least one segment, or in multiple segments with the same or different light output effects to indicate that the entire power conversion system is in different working states. When the light strip 33 is in one segment, its maximum length can be the length of tempered glass 42.

With reference to FIG. 2, the light strip 33 includes a shell 331 and a light strip body 332, the shell 331 is formed with a mounting chamber, the shell 331 is detachably connected to the surface cover 2, and the light strip body 332 is fitted into the mounting chamber.

The light strip body 332 is generally a flexible strip structure that is prone to deformation. Therefore, in order to facilitate good light output effect, in the embodiments of the present application, the light strip body 332 is mounted in the mounting chamber formed by the shell 331. The shell 331 may be made of metal or plastic, the light strip body 332 is provided with a bump, and the shell 331 is provided with an adapted clamping groove. The bump and the clamping groove achieve the fitting of the light strip body 332 and the shell 331. The shell 331 is detachably fixed to the surface cover 2 by fasteners or screws, which facilitates subsequent disassembly.

Further, the light transmission module 4 includes a back plate 41, the back plate 41 is detachably mounted on the surface cover 2, and the display screen 32 is detachably mounted on the back plate 41 and located between the back plate 41 and the surface cover 2.

The back plate 41 provides a mounting position for the display screen 32, and the display screen 32 can be detachably mounted on the back plate 41 by fastener connection, screw connection, or bolt connection. The back plate 41 can be detachably mounted on the surface cover 2 by fastener connection, screw connection, or bolt connection, which is in the same way as that for the display screen 32. In the embodiments of the present application, a plurality of second pressure riveting screw columns (not marked) are further provided on the back plate 41, pass through the surface cover 2 and are connected to corresponding screws, to achieve the detachable connection between the back plate 41 and the surface cover 2.

Further, the back plate 41 is provided with a first notch 41a, the display screen 32 is correspondingly arranged in the first notch 41a, and the shape and size of the first notch 41a can match those of the display screen 32.

As shown in FIG. 3, the display screen 32 includes a mounting seat 321 and a display screen body 322 connected to each other, and the display screen body 322 is fitted into the first notch 41a. By the first notch 41a, the image displayed by the display screen body 322 can be directly displayed, such that the back plate 41 does not affect the quality of the image displayed by the display screen body 322.

The mounting seat 321 mainly supports the display screen body 322 and is located between the back plate 41 and the surface cover 2, and the mounting seat 321 is formed with holes that allow first pressure riveting screw columns to pass through.

The back plate 41 is further provided with a second notch 41b, the second notch 41b is spaced apart from the first notch 41a, and the human body detection radar 31 can be correspondingly arranged in the second notch 41b.

The back plate 41 has a certain shielding effect, especially when the back plate 41 is made of metal, so the second notch 41b can be formed on the back plate 41. Electromagnetic waves emitted or received by the human body detection radar 31 pass through the second notch 41b. Therefore, the second notch 41b greatly reduces the impact of the back plate 41 on the human body detection radar 31.

The shapes of the first notch 41a and the second notch 41b are not limited and may be circular, square, or bar-shaped.

With continued reference to FIG. 1, the light transmission module 4 further includes a transparent protective layer 42. The transparent protective layer 42, the back plate 41, and the screen display module 3 are arranged sequentially, where an adhesive layer is provided between the transparent protective layer 42 and the back plate 41 to connect the transparent protective layer 42 and the back plate 41.

The transparent protective layer 42 may be made of tempered glass or reinforced plastic, such as thermosetting resin or thermoplastic resin. In this embodiment, in order to better exhibit the screen display module 3, tempered glass is used. The tempered glass is bonded to the back plate 41 by the adhesive layer. Generally speaking, in order to achieve better light output effect, the back plate 41 is made of metal, while the tempered glass 42 can ensure light transmission and has certain strength to prevent damage.

The adhesive layer may be a continuous adhesive area or a plurality of discontinuous adhesive areas. The adhesive layer may be transparent glue or other transparent adhesives, such as UV glue, without affecting the aesthetics of the entire light transmission module 4.

In the embodiments of the present application, after the tempered glass is bonded to the back plate 41 by the glass adhesive, in order to ensure the bonding strength between the two, they can be pressed for a period of time after being bonded together.

Specifically, for the sake of aesthetics, a plurality of first pressure riveting screw columns (not marked) are provided on the side of the back plate 41 facing the surface cover 2. The first pressure riveting screw columns pass through the display screen 32 and are connected to corresponding screws to achieve a detachable connection. The pressure riveting screw columns are connected to the back plate 41 by riveting, which can ensure a smooth state of the side of the back plate 41 facing the tempered glass 42 and facilitate the connection between the back plate 41 and the tempered glass 42.

A mounting process of the case 1 and the surface cover 2 in the present application is as follows:
When assembling, the radar body 311, the sealing cover 312, the display screen 32, and the light strip 33 are first mounted on the surface cover 2 respectively, then the first wire harness is connected to the control board in the case 1, the surface cover 2 is locked with the base 11, and the decorative cover plates 12 on two sides are finally mounted.

As one of the ways, specifically:
(1) The tempered glass 42 and the back plate 41 are bonded together by a glass adhesive and pressed for a period of time;
(2) The display screen 32 is locked with screws to the pressure riveting screw columns riveted to the back of the back plate 41;
(3) The light strip 33 is fixed to the surface cover 2 with screws;
(4) The first wire harness led out from the control board is connected to the radar body 311, and the radar body 311 is locked to the surface cover 2 with screws;
(5) After the light strip 33 and the second wire harness of the display screen 32 are connected to the radar body 311, power supply to the electronic components on the surface cover can be ensured. The sealing cover 312 is fixed to the surface cover 2 with screws, and the second wire harness passes through the waterproof rubber plug embedded in the sealing cover 312 to ensure the sealing effect;
(6) Finally, the tempered glass 42 and the back plate 41 bonded into a whole are locked to the surface cover 2, to form a complete cover assembly.

The same or similar reference numerals in the accompanying drawings of the embodiments correspond to the same or similar components. In the description of the present application, it should be understood that if the terms such as "up", "down", "left", and "right" indicate orientations or positional relationships based on the orientations or positional relationships shown in the accompanying drawings, it is only for the convenience of describing the present application and simplifying the description, and does not indicate or imply that the device or component referred to must have a specific orientation or be constructed and operated in a specific orientation. Therefore, the terms for describing the positional relationships in the accompanying drawings are only for illustrative description and cannot be understood as limitations of this patent. Those of ordinary skill in the art can understand the specific meanings of the above terms according to specific situations.

Described above are merely the preferred embodiments of the present application, which are not used for limiting the present application. Any modification, equivalent replacement and improvement, and the like made in line with the claims of the present application shall fall within the protection scope of the present application.

## Claims

1. A power conversion system, comprising:
- a case (1), wherein a control board is provided in the case (1), and the case (1) has a surface cover (2);
- a screen display module (3), wherein the screen display module (3) is located outside the case (1) and detachably mounted on the surface cover (2), and the screen display module (3) is electrically connected to the control board; and
- a light transmission module (4), wherein the light transmission module (4) covers the screen display module (3) and is detachably mounted on the surface cover (2);
- wherein the screen display module (3) comprises a human body detection radar (31) and a display screen (32), the human body detection radar (31) and the display screen (32) are spaced apart on the surface cover (2), the human body detection radar (31) is connected to the control board in the case (1) through a first wire harness, and the display screen (32) is connected to the human body detection radar (31) through a second wire harness.

2. The power conversion system according to claim 1, wherein the human body detection radar (31) comprises a radar body (311) and a sealing cover (312), the radar body (311) is connected to the surface cover (2) and connected to the control board in the case (1) through the first wire harness, and the sealing cover (312) is detachably mounted on the surface cover (2) and covers the radar body (311).

3. The power conversion system according to claim 2, wherein a first wire hole is formed on the sealing cover (312), a waterproof plug is embedded in the first wire hole, and a channel that allows the second wire harness to pass through is formed in the waterproof plug.

4. The power conversion system according to any one of the preceding claims, wherein the screen display module (3) further comprises a light strip (33).

5. The power conversion system according to claim 4, wherein the light strip (33) is connected to the human body detection radar (31) through a third wire harness.

6. The power conversion system according to claim 4, wherein the second wire harness comprises one first terminal and two second terminals, the first terminal is connected to the human body detection radar (31), and the two second terminals are connected to the light strip (33) and the display screen (32) respectively.

7. The power conversion system according to any one of claims 4 to 6, wherein a portion of a side of the surface cover (2) facing the screen display module (3) is recessed inwards to form a mounting groove (2a), the screen display module (3) is arranged at a bottom of the mounting groove (2a), and when the light transmission module (4) is mounted on the surface cover (2), a side of the light transmission module (4) facing away from the surface cover (2) is flush with an opening of the mounting groove (2a).

8. The power conversion system according to claim 7, wherein a display area (2b) is provided on the side of the surface cover (2) facing the screen display module (3), the display area transitions to the bottom of the mounting groove (2a) through a slope surface (2c), and the light strip (33) is arranged on a side of a groove bottom near the slope surface (2c) to illuminate the display area (2b).

9. The power conversion system according to claim 7 or 8, wherein the light strip (33) has multiple working modes and when the light strip (33) is in different working modes, the light transmission module (4) shows different light output effects.

10. The power conversion system according to any one of claims 4 to 9, wherein the light strip (33) comprises a segment of continuous light components or comprises a plurality of light components spaced apart.

11. The power conversion system according to claim 10, wherein at least one of the light components comprises a shell (331) and a light strip body (332), the shell (331) is formed with a mounting chamber, the shell (331) is detachably connected to the surface cover (2), and the light strip body (332) is fitted into the mounting chamber.

12. The power conversion system according to any one of the preceding claims, wherein the light transmission module (4) comprises a back plate (41), the back plate (41) is detachably mounted on the surface cover (2), and the display screen (32) is detachably mounted on the back plate (41).

13. The power conversion system according to claim 12, wherein the back plate (41) is provided with a first notch (41a), and the display screen (32) is correspondingly arranged in the first notch (41a).

14. The power conversion system according to claim 12 or 13, wherein the back plate (41) is provided with a second notch and the human body detection radar (31) is correspondingly arranged in the second notch.

15. The power conversion system according to any one of claims 12 to 14, wherein:
- the light transmission module (4) further comprises a transparent protective layer (42);
- the transparent protective layer (42), the back plate (41), and the screen display module (3) are distributed sequentially; and
- an adhesive layer is provided between the transparent protective layer (42) and the back plate (41) to connect the transparent protective layer (42) and the back plate (41).
